# EUROPÄISCHE PATENTSCHRIFT

(11) **EP 1 301 762 B1**
(45) Veröffentlichungstag und Bekanntmachung des Hinweises auf die Patenterteilung: **03.10.2007**
(21) Anmeldenummer: 01953806.5
(22) Anmeldetag: 29.06.2001
(51) Int. Cl.: G01H 11/08

(54) **PIEZOELEKTRISCHER SENSOR**
PIEZOELECTRIC SENSOR
DETECTEUR PIEZO-ELECTRIQUE

(30) Priorität: 04.07.2000 DE 10031793
(43) Veröffentlichungstag der Anmeldung: 16.04.2003
(73) Patentinhaber: Kristen, Heidemarie, 50259 Pulheim (DE); Apel, Peter, 53855 Troisdorf (DE)
(72) Erfinder: APEL, Peter, 53855 Troisdorf (DE)
(74) Vertreter: Bungartz, Klaus Peter
(86) Internationale Anmeldenummer: PCT/DE2001/002362
(87) Internationale Veröffentlichungsnummer: WO 2002/003042

(56) Entgegenhaltungen:
- EP-A- 0 233 057
- EP-A- 0 334 988
- EP-A- 0 355 289
- EP-A- 0 401 669
- EP-A- 0 434 878
- US-A- 5 481 915
- US-A- 5 517 845

## Beschreibung

Die Erfindung betrifft einen piezoelektrischen Sensor mit einem Grundträger, einem auf dem Grundträger angeordneten piezoelektrischen Messwertaufnehmer, einer den Messwertaufnehmer abdeckenden Deckschicht und einer Auswerteelektronik, wobei der Messwertaufnehmer von einer piezoelektrischen Schicht gebildet ist, der Grundträger eine mit der piezoelektrischen Schicht elektrisch in Verbindung stehende erste Kontaktschicht aufweist, die Deckschicht eine zweite Kontaktschicht aufweist, die elektrisch mit der piezoelektrischen Schicht verbunden ist und die Auswerteelektronik eine mechanische Belastung der piezoelektrischen Schicht durch Auswertung der Differenz des elektrischen Potentials zwischen der ersten Kontaktschicht und der zweiten Kontaktschicht zu bestimmen vermag.

Ein derartiger Sensor ist aus der deutschen Patentschrift 28 431 938 bekannt. Bei diesem Sensor wird als Messgröße die Ladungsverschiebung einer piezoelektrischen Folie genutzt, die über eine externe Auswerteelektronik in das gewünschte Messsignal umgewandelt wird. Diese Sensoren haben den Nachteil, dass die Wege zur Auswerteelektronik in ihrer Länge begrenzt sind und an dezentraler Stelle mit der Auswerteelektronik ein weiteres Bauteil angeordnet werden muss.

Sensoren der eingangs genannten Art sind darüber hinaus als Stoßsensor mit einer seismischen Masse bekannt, wobei die seismische Masse infolge eines Stoßes und der damit bedingten Beschleunigung gegen die piezoelektrische Schicht gedrückt wird. Dieser Druck auf die piezoelektrische Schicht wiederum bewirkt eine Ladungsverschiebung, die durch Kontaktierungen zu beiden Seiten der Oberfläche der piezoelektrischen Schicht abgegriffen und ausgewertet werden kann. Ein Sensor dieser Art ist von Gevatter in dem "Handbuch der Mess- und Automatisierungstechnik", VDI Verlag 1998, beschrieben.

Die Sensoren mit seismischer Masse weisen zusätzlich zu den Nachteilen der obengenannten, folienartigen Sensoren den Nachteil auf, dass die seismische Masse erregt werden muss. Ferner muss aufgrund der beweglichen Führung der seismischen Masse eine verhältnismäßig aufwendige Mechanik vorgesehen werden, die infolge der bewegten Teile zu hohen Herstellungskosten und zusätzlich zu einem größeren Ausfallrisiko führt. Schließlich ist der Aufbau sehr empfindlicher Sensoren nur mit unverhältnismäßig großem Aufwand möglich, da eine Messung nur möglich ist, wenn durch das schwache Signal die seismische Masse erregt wird. Ein solcher Sensor kann deshalb beispielsweise als Schwingungsmesser kaum eingesetzt werden.

Aufgabe der Erfindung ist daher, einen Sensor zu schaffen, der kostengünstig herstellbar ist und bei leichter Verbaubarkeit auf einfache Weise unter Ausnutzung des piezoelektrischen Effektes auch schwache Signale, wie zum Bespiel Schwingungen oder Materialverformungen, wirtschaftlich messen kann.

Diese Aufgabe wird nach der Erfindung dadurch gelöst, dass der Sensor zusammen mit der Auswerteelektronik in Folienstärke ausgebildet ist, wobei die piezoelektrische Schicht eine Dicke von weniger als 1 mm aufweist und die Auswerteelektronik neben dem Messwertaufnehmer auf dem folienartig ausgebildeten Grundträger angeordnet ist, der aus einem elastischen und Schwingungen nur wenig dämpfenden Material hergestellt ist.

Durch die erfindungsgemäße Ausgestaltung des Sensors wird auf die seismische Masse verzichtet, und als Messwertaufnehmer eine dünne, piezoelektrische Schicht eingesetzt, die auf dem elastisch verformbaren Grundträger angeordnet ist und dessen Verformungen in ein Messsignal umwandelt. Die Auswerteelektronik ist auf dem Grundträger angeordnet, so dass eine Übertragung des schwachen piezoelektrischen Messsignals von der Folie zur Auswerteelektronik über eine längere Distanz entfällt. So können die Kosten für die Herstellung und den Einbau des Sensors erheblich reduziert werden und der Sensor erstmals als piezoelektrischer Sensor für völlig neue Einsatzzwecke vorgesehen werden.

Wesentliche Baugruppen des neuartigen Sensors sind der flexible Grundträger und die Deckschicht sowie die dazwischen angeordnete piezoelektrische Schicht. Deckschicht und Grundträger sind so ausgestaltet, dass über sie die Ladungsverschiebung innerhalb der piezoelektrischen Schicht infolge einer Deformierung abgegriffen werden kann. Bei der Deformierung der piezoelektrischen Schicht kann es sich sowohl um eine Verwindung um eine beliebige Achse als auch um einen Druck auf die Schicht selbst in senkrechter Richtung handeln.

Alle Bauteile des Sensors sind hinreichend flexibel, so dass der Sensor, der auf eine Oberfläche aufgeklebt sein kann, die infolge des Körperschalls in dem ihn tragenden Bauteil vorhandenen Schwingungen in Schwingungen der piezoelektrischen Schicht umsetzen kann. Dies wiederum bewirkt eine sich zeitlich verändernde Ladungsschicht abhängig von der Schwingungsamplitude und -dauer, die über den Grundträger und die Deckschicht abgegriffen wird und von der Auswerteelektronik in das gewünschte Signal umgerechnet werden kann.

Der so aufgebaute Sensor kann in einer Vielzahl von Einsatzzwecken verwendet werden und, da er besonders kostengünstig herstellbar ist, oft als zusätzliches Glied in eine Regelkette integriert werden. So kann beispielsweise bei einer bevorzugten Ausgestaltung des Sensors der Sensor im Rahmen der Auslösung eines Airbags eines Kraftfahrzeugs verwendet werden, die heutzutage fast ausschließlich durch Stoßsensoren ausgelöst werden. Insbesondere bei Unfällen, in denen das Fahrzeug zunächst einem Stoß ausgesetzt ist, jedoch noch nicht verunfallt, beispielsweise bei einem Aufprall auf eine Leitplanke und anschließendem Schleudervorgang, wird so häufig der Airbag ausgelöst und, da er bereits nach wenigen Bruchteilen einer Sekunde wieder erschlafft, beim eigentlichen Crash des Fahrzeugs nicht mehr zur Verfügung stehen. In dieser Situation kann der erfindungsgemäße Sensor zusätzlich zu der Elektronik eingesetzt werden und beispielsweise auf die Innenseite eines Bleches des Fahrzeugs geklebt werden. Über die Aussetzwerteelektronik kann die Empfindlichkeit des Sensors so justiert werden, dass zusätzlich zu dem Stoß auch eine größere Deformation notwendig sein muss, um den Airbag auszulösen.

Die piezoelektrische Schicht des Sensors ist nur wenige µm dick und wird bevorzugt aus einer Folie hergestellt. Eine solche piezoelektrische Folie ist als Meterware erhältlich, wobei der Preis für 1 m² Folie etwa dem Preis der bisher verwendeten piezoelektrischen Sensoren mit seismischer Masse entspricht. Aus 1 m² Folie lassen sich eine Vielzahl von Sensoren herstellen, so dass unter Berücksichtigung der Tatsache, dass die übrigen Bauteile des Sensors keine wesentlichen Kosten verursachen, der erfindungsgemäße Sensor circa 10 bis 50 Mal günstiger herstellbar ist als die bisher bekannten und eingesetzten Sensoren. Dies macht den Einsatz an vielen Stellen erst rentabel. Auch eine mehrfache Überwachung durch Verwendung mehrerer Sensoren wird nun möglich und wirtschaftlich.

Durch die Verwendung der piezoelektrischen Folie mit nahezu beliebiger Form kann zum Beispiel ein Stoßsensor als Einklemmschutz aufgebaut werden. So kann zum Beispiel im Falle eines Rolltores eine untere Gummilippe mit dem Messwertaufnehmer versehen werden, wobei der Grundträger von einer äußeren Gummischicht und die Deckschicht von einer inneren Gummischicht gebildet sind. Bei Kontakt der Gummilippe an einer beliebigen Stelle wird der Sensor ein Signal abgeben, das zur Endabschaltung oder zur Abschaltung im Falle eines Einklemmens genutzt werden kann. Dies kann auch für Türen eines öffentlichen Verkehrsmittels oder für elektrische Fensterheber genutzt werden.

Weitere beispielhafte Anwendungsfälle des erfindungsgemäßen Sensors sind die Ermittlung von Schwingungen infolge von Maschinenschäden, wie sie etwa in Pumpengehäusen, bei Wellenlagerungen oder auch im Schienenfahrzeugbau auftreten können. So kann beispielsweise der den Zugbetrieb gefährdende Bruch eines Radreifens durch die zusätzlichen Schwingungen, die infolge des Bruches entstehen, detektiert werden und rechtzeitig vor einem Entgleisen des Zuges ein Signal gegeben werden bzw. ein Regeleingriff vorgenommen werden. Im Falle eines Pumpengehäuses, das üblicherweise eine gleichförmige Schwingung infolge des Planschens der zu pumpenden Flüssigkeit bzw. infolge der Lagergeräusche ertragen muss, kann im Falle eines Lagerschadens diese Abweichung der üblichen Frequenzen bzw. Amplituden ermittelt werden und vor einem größeren Schaden eingegriffen werden. Schließlich kann der Sensor auch für den Aufbau von Alarmanlagen oder Bewegungsmeldern genutzt werden, etwa wenn Schaufensterscheiben oder Kraftfahrzeuge vor mutwilligem Zerkratzen bewahrt werden sollen.

Bevorzugt ist der Grundträger aus einem flexiblen Material hergestellt, beispielsweise einem flexiblen Kunststoff. Auf dieses Material kann dann die erste Kontaktschicht aufgebracht werden, die beispielsweise von einer aufgedampften Silberschicht gebildet sein kann. Auch das Aufkleben einer Blechfolie oder einer Folie aus einem sonstigen leitenden Material ist möglich.

Bei einer bevorzugten Ausgestaltung der Erfindung ist dabei der Grundträger in zwei Bereiche unterteilt, wobei in einem Sensorbereich der eigentliche Sensor angeordnet ist, während in einem daneben liegenden Bereich zumindest ein Teil der Auswerteelektronik angeordnet ist. Im Sensorbereich wird dann unter Belassung eines Randes die erste Kontaktschicht aufgebracht, auf die dann mit gleicher Größe die dünne piezoelektrische Folie aufgeklebt werden kann. Auf diese piezoelektrische Folie wiederum wird die Deckschicht aufgebracht, die im Bereich der piezoelektrischen Folie die zweite Kontaktschicht aufweist. Auch diese zweite Kontaktschicht kann auf die Deckschicht aufgedampft oder als Folie aufgeklebt sein. Die erste Kontaktschicht und die zweite Kontaktschicht sind dann mit der Auswerteelektronik verbunden, weisen insbesondere eine Kabelverbindung zu entsprechenden Kontakten auf oder sind so ausgestaltet, dass sie leiterbahnartige Verlängerungen in Richtung der Auswerteelektronik aufweisen, die dann mit den entsprechenden Kontakten verbunden sind.

Bei einer alternativen Ausgestaltung der Erfindung kann die Kontaktschicht auch inner- oder unterhalb des Grundträgers bzw. der Deckschicht angeordnet sein, wobei dann der elektrische Kontakt zur piezoelektrischen Schicht über durchgängige Kontaktierungen erfolgt.

Bevorzugte Dicken der piezoelektrischen Schicht sind weniger als 1 mm, insbesondere nur wenige µm, insbesondere weniger als 20 µm, wobei auch Dicken unterhalb von 10 µm möglich sind. Bei einer konkreten Ausgestaltung des Sensors als Schwingungsmesser wird beispielsweise eine Dicke der piezoelektrischen Schicht von 6 µm verwendet. Diese piezoelektrische Folie ist mit dem Grundträger und der Deckschicht unter Einschluss der ersten Kontaktschicht und der zweiten Kontaktschicht verbunden, wobei die Verbindung insbesondere durch Verkleben während des Herstellungsprozesses bewirkt wird.

Der Grundträger kann aus einem elektrisch nicht leitfähigen Material hergestellt sein, es ist jedoch auch möglich, dass der Grundträger selbst leitend ist. In diesem Fall entfällt die Notwendigkeit, eine gesonderte erste Kontaktschicht aufzubringen und es ist ausreichend, wenn der Grundträger selbst die erste Kontaktschicht bildet. Gleiches gilt analog für die Deckschicht, die selbstverständlich auch elektrisch leitend ausgebildet sein kann. Der Grundträger und die Deckschicht können eine Dicke von weniger als 1 mm aufweisen, eine Materialstärke zwischen 120 µm und 160 µm wird dabei besonders bevorzugt. Die erste Kontaktschicht und die zweite Kontaktschicht weisen im Falle eines konkreten Ausführungsbeispiels eine Dicke von 5 bis 50 µm auf, so dass sich eine Gesamtdicke des Sensors im Bereich des Messwertaufnehmers von weniger als 300 µm (ohne Gehäuse) ergibt

Durch den Fortfall der seismischen Masse kann der Sensor also sehr dünn gehalten werden, was einen Einsatz dort ermöglicht, wo bisher keine piezoelektrischen Sensoren bzw. überhaupt keine Sensoren eingesetzt werden können. Gleichzeitig weist der Sensor eine gute Druckfestigkeit auf. So kann er als Unterlegscheibe einer Schraubenverbindung eingesetzt werden, wobei der Messwertaufnehmer von der Schraubenkraft eingespannt wird und die Auswerteelektronik neben dem Sensor angeordnet ist. Mit diesem Sensor kann die Schraubenkraft und eine Stoßbelastung auf die Schraube überwacht werden und beispielsweise ein Lösen der Schraube oder eine unzulässige Spannung frühzeitig erkannt werden.

Die Möglichkeit des Einsatzes des Sensors als druckbelasteter Stoßsensor in einer Schraubenverbindung ermöglicht die Messung und Regelung der Siegelkraft einer Verpackungsmaschine, bei der zwei Werkzeughälften im Rahmen der Vakuumverpackung gegeneinander angestellt werden. Hier kann über die Messung der Haltekraft der Spannschrauben die Siegelkraft gemessen und gegebenenfalls auch geregelt werden. Schließlich kann über einen solchen Sensor zum Beispiel auch ein Innendruck in einem Hohlraum gemessen werden.

Im Falle eines Extruders kann etwa über die nach dem obengenannten Prinzip gemessene Haltekraft der Schrauben, mit denen der Düsenkopf an dem Extrudergehäuse befestigt ist, der Innendruck im vorderen Extruderbereich gemessen werden, ohne dass über aufwendige konstruktive Lösungen ein Druckmesser in den Innenraum geführt werden müsste. Im Falle eines Otto-Motors könnte ein Sensor im Bereich des Nockens der Ventilsteuerung angeordnet sein, der die Zuhaltekraft des Ventils misst und damit den Druck im Brennraum. Hiermit kann bei Vergleich der Innendrücke der Zylinder ein Defekt schnell und sicher ohne großen Aufwand erkannt werden.

Durch den Verzicht auf die seismische Masse ergibt sich bei geringen Herstellungskosten ein sehr empfindlicher Sensor. Ein nach dem oben beschriebenen Prinzip hergestellter Sensor kann zum Beispiel, aufgeklebt auf eine Tischplatte, detektieren, ob in einem Raum gesprochen wird oder nicht. Er ist also so empfindlich, dass er die auf die Tischplatte übertragenen und dort als Körperschall weitergeleiteten Schallwellen in ein Messsignal umwandeln kann. Ein konventioneller piezoelektrischer Sensor mit seismischer Masse würde eine sehr aufwendige Lagerung dieser Masse erfordern.

Die erste und die zweite Kontaktschicht können für den Aufbau eines noch sensibleren Sensors auch in Segmente unterteilt sein, wobei die Auswerteelektronik dann jeweils die Potentialdifferenz zweier gegenüber liegender Segmente der ersten und der zweiten Kontaktschicht abgreifen sollte. Auf diese Weise kann nicht nur eine räumliche Information über die Ladungsverschiebung innerhalb der piezoelektrischen Schicht erhalten werden, sondern auch das Ausfallrisiko des Sensors verringert werden, da mehrere Kontakte vorhanden sind und der Ausfall eines Segmentpaares nicht zum Ausfall des Sensors führen wird. Insbesondere im Falle einer selbsttätigen Kalibrierung des Sensors wird im Falle des Ausfalles eines Sensorpaares, etwa infolge eine Kabelbruches, durch den nachfolgenden Kalibriervorgang der Sensor so eingestellt, dass benachbarte Segmente die Funktion des ausgefallenen Teiles übernehmen können.

Der Sensor ist bevorzugt zusammen mit der Auswerteelektronik in ein Gehäuse integriert, wobei dieses besonders leicht durch Eingießen der funktionalen Bauteile in einen Kunststoffblock geschaffen werden kann. Der Grundträger kann auf einer weiteren Trägerplatte installiert sein, die auf den eigentlichen Einsatzort, beispielsweise einem Fahrzeugblech oder einem Pumpengehäuse, montiert werden kann. Zur Übertragung der Schwingungen des Gehäuses, die im Falle eines Schwingungsmessers gemessen werden sollen, ist entweder der Grundträger oder das dazwischen liegende zusätzliche Trägerelement mit dem jeweils zu überwachenden Gehäuse verklebt.

Anstelle eines festen Gehäuses kann das Gehäuse auch von einer Folie gebildet sein, die die übrigen funktionalen Teile des eigentlichen Sensors umhüllt. Hierzu kann beispielsweise, ähnlich wie es aus der Technik der Vakuum-Verpackung bekannt ist, eine untere und eine obere Folie vorgesehen werden, wobei der Sensor entweder vollständig oder teilweise zwischen diesem Folien angeordnet ist. Die Folien werden nach Evakuieren des Zwischenraumes über eine umlaufende Naht miteinander verbunden, etwa durch Verschweißen oder über eine Klebenaht. Der so hergestellte Sensor kann dann zum Beispiel auf das zu überwachende Bauteil aufgeklebt werden.

Die Auswerteelektronik weist bevorzugt einen programmierbaren Verstärker auf, der es ermöglicht, die Auswerteelektronik an die zu messende Schwingung im Verhältnis zum Hintergrundsignal anzupassen. Die Auswerteelektronik kann vollständig auf dem Grundträger angeordnet sein, es ist jedoch auch möglich, dass die Auswerteelektronik nur teilweise auf dem Grundträger angeordnet ist und ein externer Teil der Auswerteelektronik in einem gesonderten Gehäuse untergebracht ist. Dieses wird dann insbesondere über Digitalkabel oder sonstige, einem üblichen Bus-Standard entsprechende Kabel mit dem eigentlichen Sensor verbunden. Sowohl die Auswerteelektronik auf dem Grundträger als auch eine externe Auswerteelektronik weisen bevorzugt eine Schnittstelle für ein Standard-Bus-System auf. Auf diese Weise kann der erfindungsgemäße Sensor leicht und einfach in eine Steuerung beispielsweise im Rahmen einer überwachten Fabrikation integriert werden.

Bevorzugt weist die Auswerteelektronik einen Signalprozessor und einen Programmspeicher auf, in dem eine Software abgelegt ist, die den Sensor steuert und die Messung bzw. die gemessene Größe auswertet. Die Software bestimmt anhand einer Frequenzanalyse des zeitlichen Verlaufs der gemessenen Potentialdifferenz eine ungewöhnliche Frequenzänderung und gibt in diesem Fall ein Signal aus. So kann beispielsweise das durch Planschen und Lagergeräusche verursachte regelmäßige Pumpgeräusch im Falle einer Pumpenüberwachung kein Signal auslösen, während ein Schaden in einer Lagerschale und eine dadurch verursachte ungewöhnliche Frequenz des Körperschalles ein Kontrollsignal auslöst bzw. gar ein Herunterfahren oder Entlasten der Pumpe bewirken kann.

Um die Funktion ausführen zu können, muss die Software das übliche Betriebsgeräusch von ungewöhnlichen Geräuschen unterscheiden können. Hierzu ist bevorzugt eine selbsttätige Kalibrierroutine vorgesehen, die von Zeit zu Zeit und bei Beginn des Betriebs durchgeführt. Die Software zeichnet hierzu während einer vorgegebenen Periodendauer die zeitliche Änderung des Körperschalles auf, wobei diese Periodendauer zunächst als Normalfall interpretiert wird. Bei folgenden Messungen wird dann das Messsignal jeweils mit dem in der Referenzperiode gemessenen Signal verglichen und eine ungewöhnliche Abweichung als Fehler bzw. Schaden interpretiert. In diesem Fall kann ein Alarm ausgegeben werden oder selbsttätig in die Regelung des überwachten Gerätes eingegriffen werden. Zur Vermeidung von Fehlalarmen bzw. sonstigen Fehlfunktionen kann eine Toleranzgrenze vorgegeben werden, die überschritten werden muss, damit das Fehlersignal ausgegeben wird. Diese Toleranzgrenze kann ebenfalls einstellbar ausgeführt werden.

Durch spezielle Ausgestaltung der Auswerteelektronik kann der prinzipiell als dynamischer Sensor arbeitende Sensor auch zumindest über einen gewissen Zeitbereich als statischer eingesetzt werden. Hierzu weist die Elektronik einen Integrierer auf, der das gemessene Signal integriert und damit den aktuellen Zustand auch ohne zeitliche Änderung des Signals bestimmt. Durch Verwendung einer digitalen Auswerteelektronik kann auch dauerhaft der Wert der gemessenen Größe bestimmt werden.

Über eine zusätzliche Druckmasse kann der erfindungsgemäße Sensor auch als Drucksensor oder als Beschleunigungssensor eingesetzt werden. Diese Druckmasse kann zum Beispiel von einer ebenen Druckplatte gebildet sein, die rechtwinklig zu dem Sensor verschiebbar gelagert ist. Der Sensor kann zwischen einer Oberfläche eines zu überwachenden Bauteils und der Druckplatte angeordnet sein, wobei durch eine zusätzliche Federkraft zwischen der Druckplatte und dem Sensor eine Beschleunigung in beide Richtungen gemessen werden kann. Diese zusätzliche Druckkraft kann von einer oder mehreren Federn oder auch von einer elastischen Zwischenschicht gebildet sein, die beispielsweise zwischen dem Sensor und der Druckplatte angeordnet ist und eine kontinuierliche Belastung des Sensors bewirkt.

Bei Beschleunigung der Druckplatte wird dann entweder eine Kraft in Richtung des Messwertaufnehmers oder eine Entlastung des Messwertaufnehmers erzielt, die eine Ladungsverschiebung innerhalb der piezoelektrischen Schicht bewirkt. Die Druckplatte kann den gesamten Sensor abdecken oder auch nur auf einen Teilbereich wirken. Im Falle einer möglichen Ausgestaltung des als Beschleunigungsmesser ausgebildeten Sensors kann das Gehäuse auf ein zu überwachendes Bauteil aufgeschraubt sein und die Druckplatte genügend große Durchgangsbohrungen aufweisen, so dass sie mit den verwendeten Schrauben am Sensor befestigt werden kann. Das Gehäuse muss natürlich in diesem Fall so ausgestaltet sein, dass eine Übertragung der Druckkräfte von der Druckplatte auf den piezoelektrischen Messwertaufnehmer möglich ist.

Mit dieser Erweiterung des Messwertaufnehmers wird zwar wieder eine seismische Masse eingebaut, jedoch können nun die günstigen Eigenschaften des erfindungsgemäßen Sensors mit dem zusätzlichen Leistungsmerkmal Beschleunigungsmessung kombiniert werden. So kann etwa ein sehr empfindlicher, kostengünstiger Sensor nach dem erfindungsgemäßen Prinzip aufgebaut werden, der auch eine Beschleunigung ohne Verwindung oder sonstige Deformation eines Bauteiles detektieren kann. Im Gegensatz hierzu könnte zwar ein herkömmlicher Sensor mit seismischer Masse die Beschleunigung messen, müsste um aber zum Erzielen der gleichen Empfindlichkeit bei Messung von Körperschall sehr viel aufwendiger aufgebaut werden, da Schwingungen nur dann gemessen werden können, wenn die seismische Masse erregt wird. Auf diesen Umweg über die Ausnutzung der Massenerregung kann durch die Erfindung verzichtet werden.

Weitere Merkmale und Vorteile der Erfindung ergeben sich aus den Unteransprüchen und aus der nachfolgenden Beschreibung bevorzugter Ausführungsbeispiele anhand der Zeichnungen.

In den Zeichnungen zeigt:
- Fig. 1: eine Seitenansicht eines erfindungsgemäßen Sensors,
- Fig. 2: eine Draufsicht auf den in Figur 1 dargestellten Sensor und
- Fig. 3: eine Vernetzung mehrerer Sensoren zur Überwachung einer industriellen Fertigung.

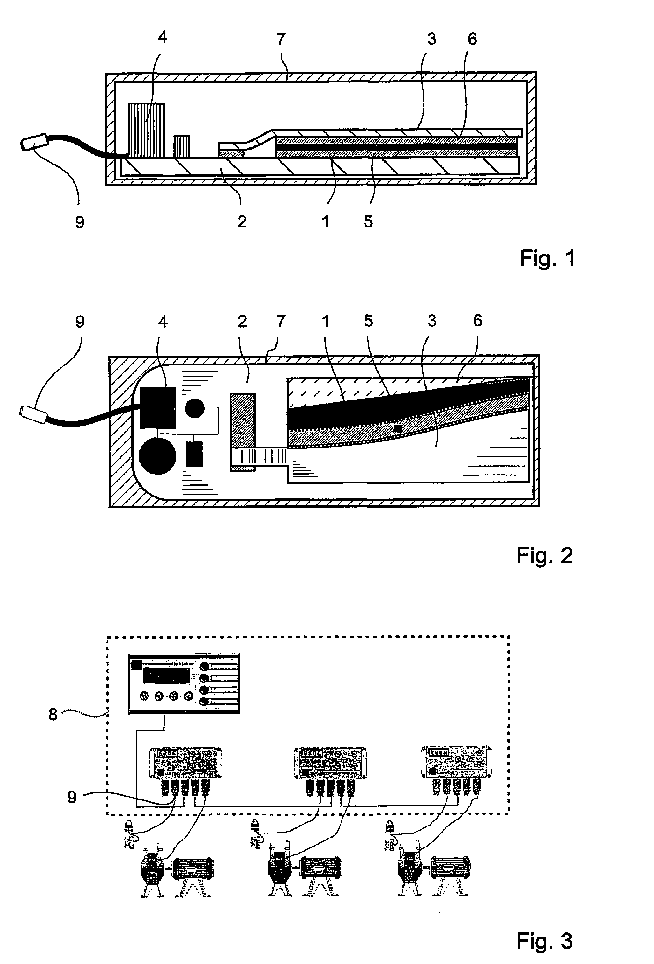

In Fig. 1 ist ein piezoelektrischer Sensor dargestellt, der von einem Grundträger 2 und einer darauf angeordneten folienartigen piezoelektrischen Schicht 1 gebildet ist. Die piezoelektrische Schicht 1 ist durch eine Deckschicht 3 abgedeckt, wobei sowohl die Deckschicht 3 als auch der Grundträger 2 auf Seiten der piezoelektrischen Schicht 1 elektrisch leitend ausgebildet ist. Hierzu ist der Grundträger 2 zumindest an seiner der piezoelektrischen Schicht 1 zugewandten mit einer ersten Kontaktschicht 5 und die Deckschicht 3 mit einer zweiten Kontaktschicht 6 versehen. Beide Schichten, die erste Kontaktschicht 5 und die zweite Kontaktschicht 6 können durch Aufdampfen auf das jeweilige Bauteil hergestellt werden, alternativ können auch dünne Metall- oder Edelmetallfolien aufgeklebt werden.

Die Deckschicht 3 ist im vorderen Bereich mit dem Grundträger 2 verbunden, wobei die leitende zweite Kontaktschicht 6 über Leiterbahnen mit einer ebenfalls auf dem Grundträger angeordneten internen Auswerteelektronik 4 verbunden ist. Ebenfalls über Leiterbahnen ist die erste Kontaktschicht 5 mit der Auswerteelektronik 4 verbunden. Diese Auswerteelektronik 4 kann die vollständige Auswertung des Messsignals vornehmen oder auch nur einen Teil der Signalverarbeitung übernehmen und ein Zwischensignal an eine (hier nicht dargestellte) externe Signalverarbeitung 8 übergeben. Hierzu ist das Anschlusskabel im dargestellten beispielhaften Fall mit einer standardisierten Schnittstelle 9 versehen, die einen leichten Anschluss des Sensors an ein Feldbussystem ermöglicht.

Aus Gründen der Darstellbarkeit sind in den Figuren die Abmessung nicht maßstabsgetreu wiedergegeben. Die piezoelektrische Schicht 1 wird in der Praxis wie auch die erste Kontaktschicht 5 und die zweite Kontaktschicht 6 wesentlich dünner sein. Im gezeigten Ausführungsbeispiel ist der Sensor von einem Gehäuse 7 umgeben, das hier als Hohlgehäuse dargestellt ist. Bevorzugt wird das Gehäuse 7 allerdings um die funktionalen Bauteile herumgespritzt, so dass diese dann luftfrei umschlossen sind. Das Gehäuse 1 kann auch den Grundträger 2 umschließen oder seitlich mit diesem abschließen. In beiden Fällen muss das Gehäuse 7 so ausgelegt werden, dass eine Verwindung der piezoelektrischen Schicht 1 analog zur Schwingung oder Verformung des Bauteiles, auf dem der Sensor angeordnet ist, möglich bleibt.

In Figur 2 ist der in Figur 1 dargestellte Sensor in einer Draufsicht, teilweise im Schnitt, gezeigt. Im rechten Bereich ist in Sandwichbauweise die piezoelektrische Schicht 1 mit der Deckschicht 3 und, jeweils dazwischen liegend, mit der ersten Kontaktschicht 5 und der zweiten Kontaktschicht 6 auf dem Grundträger 2 angeordnet. Die interne Auswerteelektronik ist hier schematisiert dargestellt und besteht aus einer Miniplatine mit den üblichen elektronischen Komponenten zur Signalverarbeitung, die von dem linken Teil des Grundträgers 2 gebildet oder auf diesen aufgesetzt sein kann. Die Deckschicht 3, beispielsweise eine dünne Silberfolie, ist in dem zur Auswerteelektronik 4 zugewandten Bereich mit einem Kontaktelement verbunden, das wiederum über herkömmliche Leiterbahnen mit der Auswerteelektronik 4 verbunden ist. Auch die Kontaktierung der unten liegenden ersten Kontaktschicht 5 erfolgt auf ähnliche Weise.

Bei einer der möglichen Ausgestaltungen der Erfindung wird die Auswertung des Messsignals nicht ausschließlich über die interne Auswerteelektronik 4 vorgenommen. In diesem Fall wird die Schnittstelle 9 dann zur Verbindung mit einer externen Auswerteelektronik 8 genutzt, die die weitere Signalverarbeitung übernimmt. Hierüber kann dann eine Triggerung und Initialisierung des Sensors vorgenommen wer den. Insbesondere bei sehr schwachen Signalen, die beispielsweise bei Einsatz des Sensors als Schwingungssensor zum Detektieren von Störsignalen auftreten können, kann über eine externe Auswerteelektronik 8 der für die Miniaturisierung erforderliche Aufwand reduziert werden.

In Figur 3 ist eine beispielhafte Anwendung der Erfindung gezeigt, bei der Störungen und Schäden von Pumpen durch Überwachung des Körperschalls im Pumpengehäuse ermittelt werden. Hierbei treten übliche Schwingungen durch die Pumpgeräusche auf, die im Falle eines Schadens, beispielsweise bei Beschädigung eines Pumpenrades, in der Frequenz oder Amplitude verändert sind. Der erfindungsgemäße Sensor misst hierzu zunächst das "normale" Pumpengeräusch und legt es als Betriebsgeräusch fest. Bei Änderungen dieses Geräusches kann dann durch Frequenzanalyse herausgefiltert werden und die Änderung als Fehler oder übliche betriebsbedingte Änderung interpretiert werden.

Die einzelnen Sensoren sind in dem in Figur 3 dargestellten Anwendungsfall über einen Feldbus miteinander verbunden, der den Anschluss der Schnittstellen 9 an die externe Auswerteelektronik 8 ermöglicht. Ein gemeinsames Auswerte- und Steuergerät ist hierzu unter Zwischenschalten jeweils eines Anzeige- und Bedienelementes mit den Sensoren verbunden. Über übliche Regelkreise können bei Fehlererkennungen die erforderlichen Maßnahmen ergriffen werden.

### Bezugszeichenliste:

- 1: Piezoelektrische Schicht
- 2: Grundträger
- 3: Deckschicht
- 4: Auswerteelektronik
- 5: Erste Kontaktschicht
- 6: Zweite Kontaktschicht
- 7: Gehäuse
- 8: Externe Auswerteelektronik
- 9: Schnittstelle zum Anschluss an einen Bus

## Patentansprüche

1. Piezoelektrischer Sensor mit einem Grundträger (2), einem auf dem Grundträger (2) angeordneten piezoelektrischen Messwertaufnehmer, einer den Messwertaufnehmer abdeckenden Deckschicht (3) und einer Auswerteelektronik (4), wobei der Messwertaufnehmer von einer piezoelektrischen Schicht (1) gebildet ist, der Grundträger (2) eine mit der piezoelektrischen Schicht (1) elektrisch in Verbindung stehende erste Kontaktschicht (5) aufweist, die Deckschicht (3) eine zweite Kontaktschicht (6) aufweist, die elektrisch mit der piezoelektrischen Schicht (1) verbunden ist und die Auswerteelektronik (4) eine mechanische Belastung der piezoelektrischen Schicht (1) durch Auswertung der Differenz des elektrischen Potentials zwischen der ersten Kontaktschicht (5) und der zweiten Kontaktschicht (6) zu bestimmen vermag, **dadurch gekennzeichnet, dass** der Sensor zusammen mit der Auswerteelektronik in Folienstärke ausgebildet ist, wobei die piezoelektrische Schicht (1) eine Dicke von weniger als 1 mm aufweist und die Auswerteelektronik (4) neben dem Messwertaufnehmer auf dem folienartig ausgebildeten Grundträger (2) angeordnet ist, der aus einem elastischen und Schwingungen nur wenig dämpfenden Material hergestellt ist.

2. Piezoelektrischer Sensor nach Anspruch 1, **dadurch gekennzeichnet, dass** der Grundträger und die piezoelektrische Schicht flächig haftend miteinander verbunden sind.

3. Piezoelektrischer Sensor nach dem vorhergehenden Anspruch, **dadurch gekennzeichnet, dass** die Dicke der piezoelektrischen Schicht (1) kleiner als 10µm ist.

4. Piezoelektrischer Sensor nach einem der vorhergehenden Ansprüche, **dadurch gekennzeichnet, dass** der Grundträger (2) eine aus einem nicht elektrisch leitfähigen Material hergestellte Trägerschicht aufweist, die mit der ersten Kontaktschicht (5) versehen ist und auf der, neben der piezoelektrischen Schicht (1), die Auswerteelektronik (4) angeordnet ist.

5. Piezoelektrischer Sensor nach einem der vorhergehenden Ansprüche, **dadurch gekennzeichnet, dass** neben der Auswerteelektronik (4) in Sandwichbauweise ein flächiger Sensorbereich aufgebaut ist, wobei der Grundträger (2) im Sensorbereich mit der ersten Kontaktschicht (5) versehen ist, auf der ersten Kontaktschicht (5), elektrisch mit dieser verbunden, die piezoelektrische Schicht (1) und hierauf die Deckschicht (3) angeordnet ist, die die der piezoelektrischen Schicht (1) zugewandte leitfähige zweite Kontaktschicht (6) aufweist.

6. Piezoelektrischer Sensor nach einem der vorhergehenden Ansprüche, **dadurch gekennzeichnet, dass** der Grundträger (2) und/oder die Deckschicht (3) von einer flexiblen Folie gebildet sind, deren Dicke geringer als 200 µm ist.

7. Piezoelektrischer Sensor nach einem der vorhergehenden Ansprüche, **dadurch gekennzeichnet, dass** Dicke der ersten Kontaktschicht (5) und die Dicke der zweiten Kontaktschicht (6) jeweils geringer als 70 µm ist.

8. Piezoelektrischer Sensor nach einem der vorhergehenden Ansprüche, **dadurch gekennzeichnet, dass** er ein die übrigen Bauteile aufnehmendes Gehäuse (7) aufweist.

9. Piezoelektrischer Sensor nach einem der vorhergehenden Ansprüche, **dadurch gekennzeichnet, dass** das Gehäuse (7) durch Umgießen des Sensors mit Kunststoff hergestellt ist.

10. Piezoelektrischer Sensor nach einem der vorhergehenden Ansprüche, **dadurch gekennzeichnet, dass** das Gehäuse (7) von einer oberen und unteren Folie gebildet ist, die durch eine, die übrigen Teile des Sensors umlaufende Verbindungsnaht miteinander verbunden sind.

11. Piezoelektrischer Sensor nach einem der vorhergehenden Ansprüche, **dadurch gekennzeichnet, dass** die erste Kontaktschicht (5) und die zweite Kontaktschicht (6) von dünnen Folien eines metallischen Materials gebildet sind.

12. Piezoelektrischer Sensor nach dem vorhergehenden Anspruch, **dadurch gekennzeichnet, dass** die Folien der ersten Kontaktschicht (5) und der zweiten Kontaktschicht (6) zumindest jeweils eine kabelartige Verlängerung aufweisen, die mit der Auswerteelektronik (4) zur Kontaktierung verbunden ist.

13. Piezoelektrischer Sensor nach einem der vorhergehenden Ansprüche, **dadurch gekennzeichnet, dass** die erste Kontaktschicht (5) und die zweite Kontaktschicht (6) in durch elektrisch isolierende Spalten Segmente unterteilt sind und die Auswerteelektronik (4) mit jedem der Segmente derart verbunden ist, dass sie die Potentialdifferenz zwischen einem Paar von Segmenten der ersten Kontaktschicht (5) und der zweiten Kontaktschicht (6) zu bestimmen vermag.

14. Piezoelektrischer Sensor nach einem der vorhergehenden Ansprüche, **dadurch gekennzeichnet, dass** die Auswerteelektronik (4) einen programmierbaren Verstärker aufweist.

15. Piezoelektrischer Sensor nach einem der vorhergehenden Ansprüche, **dadurch gekennzeichnet, dass** die Auswerteelektronik (4) eine Schnittstelle (9) zum Anschluss an einen Feldbus, insbesondere an einen CAN-Bus aufweist.

16. Piezoelektrischer Sensor nach einem der vorhergehenden Ansprüche, **dadurch gekennzeichnet, dass** die Auswerteelektronik (4) einen Signalprozessor und einen Programmspeicher mit darauf gespeicherter Software aufweist, wobei die Software zum Messen von Körperschall anhand der Frequenzanalyse der gemessenen Potentialdifferenz eine ungewöhnliche Frequenzänderung zu detektieren vermag.

17. Piezoelektrischer Sensor nach dem vorhergehenden Anspruch, **dadurch gekennzeichnet, dass** die Software eine Kalibrierroutine aufweist, die nach einer vorgegebenen Periode die zeitliche Änderung des Körperschalls als Normalfall bestimmt und diesen den nachfolgenden Kontrollmessungen zugrundelegt, wobei das gemessene Signal mit demjenigen des Normalfalls verglichen wird und die Software bei Abweichungen oberhalb einer vorgegebenen Toleranzgrenze ein Signal auszugeben vermag.

18. Piezoelektrischer Sensor nach einem der vorhergehenden Ansprüche, **dadurch gekennzeichnet, dass** er eine zweite externe Auswerteelektronik (8) aufweist, die über eine digitale Verbindung mit der Auswerteelektronik (4) verbunden ist und eine Schnittstelle (9) zum Anschluss an ein Feldbussystem aufweist.

19. Piezoelektrischer Sensor nach einem der vorhergehenden Ansprüche, **dadurch gekennzeichnet, dass** er eine zur piezoelektrischen Schicht (1) parallel angeordnete Druckplatte aufweist, die in der zur piezoelektrischen Schicht (1) rechtwinkligen Richtung beweglich geführt ist.

20. Piezoelektrischer Sensor nach dem vorhergehenden Anspruch, **dadurch gekennzeichnet, dass** zwischen der piezoelektrischen Schicht (1) und der Druckplatte ein unter Vorspannung stehendes federndes Element angeordnet ist.

## Claims

1. A piezoelectric sensor comprising a carrier (2), a piezoelectric measurement sensing element arranged on the carrier (2), a covering layer (3) covering the measurement sensing element and an electronic evaluation unit (4), the measurement sensing element being formed by a piezoelectric layer (1), the carrier (2) having a first contact layer (5) electrically connected to the piezoelectric layer (1), the covering layer (3) having a second contact layer (6) electrically connected the piezoelectric layer (1) and the electronic evaluation unit (4) being able to determine a mechanical loading of the piezoelectric layer (1) by evaluating the difference of electric potential between the first contact layer (5) and the second contact layer (6), **characterized in that** the sensor together with the electronic evaluation unit is configured to have the thickness of a film, the piezoelectric layer (1) having a thickness of less than 1 mm and the electronic evaluation unit (4) being arranged beside the measurement sensing element on the film-like carrier (2) which is manufactured from an elastic material which damps vibrations to only a slight degree.

2. A piezoelectric sensor according to claim 1, **characterized in that** the carrier and the piezoelectric layer are joined together in a planarly adhering manner.

3. A piezoelectric sensor according to the preceding claim **characterized in that** the thickness of the piezoelectric layer (1) is less than 10 µm.

4. A piezoelectric sensor according to one of the preceding claims, **characterized in that** the carrier (2) has a carrier layer made of an electrically non-conductive material which is provided with the first contact layer (5) and on which, beside the piezoelectric layer (1), the electronic evaluation unit (4) is arranged.

5. A piezoelectric sensor according to one of the preceding claims, **characterized in that** next to the electronic evaluation unit (4) a planar sensor area is built up in a sandwich structure, the carrier (2) being provided in the sensor area with a first contact layer (5), the piezoelectric layer (1) being arranged on the first contact layer (5) and electrically connected thereto and the covering layer (3) having the conductive second contact layer (6) which faces towards the piezoelectric layer (1) being arranged on the latter.

6. A piezoelectric sensor according to one of the preceding claims, **characterized in that** the carrier (2) and/or the covering layer (3) is/are formed by a flexible film the thickness of which is less than 200 µm.

7. A piezoelectric sensor according to one of the preceding claims, **characterized in that** the thickness of the first contact layer (5) and the thickness of the second contact layer (6) are in each case less than 70 µm.

8. A piezoelectric sensor according to one of the preceding claims, **characterized in that** it has a housing (7) containing the other components.

9. A piezoelectric sensor according to one of the preceding claims, **characterized in that** the housing (7) is manufactured by moulding of plastics material around the sensor.

10. A piezoelectric sensor according to one of the preceding claims, **characterized in that** the housing (7) is formed by an upper and a lower film which are joined together by a connecting seam surrounding the remaining components of the sensor.

11. A piezoelectric sensor according to one of the preceding claims, **characterized in that** the first contact layer (5) and the second contact layer (6) are formed by thin foils of a metallic material.

12. A piezoelectric sensor according to the preceding claim, **characterized in that** the foils of the first contact layer (5) and the second contact layer (6) have in each case at least one cable-like prolongation which is connected to the electronic evaluation unit (4) for bonding.

13. A piezoelectric sensor according to one of the preceding claims, **characterized in that** the first contact layer (5) and the second contact layer (6) are subdivided into segments by means of electrically insulating gaps and the electronic evaluation unit (4) is connected to each of the segments in such a way that it can determine the potential difference between a pair of segments of the first contact layer (5) and of the second contact layer (6)

14. A piezoelectric sensor according to one of the preceding claims, **characterized in that** the electronic evaluation unit (4) includes a programmable amplifier.

15. A piezoelectric sensor according to one of the preceding claims, **characterized in that** the electronic evaluation unit (4) has an interface (9) for connection to a field bus, in particular a CAN bus.

16. A piezoelectric sensor according to one of the preceding claims, **characterized in that** the electronic evaluation unit (4) includes a signal processor and a program memory with software stored therein, the software being able to detect an unusual frequency change by means of frequency analysis of the measured potential difference for measurement of solid-borne sound.

17. A piezoelectric sensor according to the preceding claim, **characterized in that** the software includes a calibrating routine which after a preset period identifies the change over time of the solid-borne sound as the normal case and uses the latter as the basis for subsequent control measurements, the measured signal being compared to that of the normal case and the software being able to emit a signal in case of deviations above a preset tolerance limit.

18. A piezoelectric sensor according to one of the preceding claims, **characterized in that** it has a second external electronic evaluation unit (8) which is connected to the electronic evaluation unit (4) via a digital connection and has an interface (9) for connection to a field bus system.

19. A piezoelectric sensor according to one of the preceding claims, **characterized in that** it has a pressure plate arranged parallel to the piezoelectric layer (1), which pressure plate is guided movably in a direction perpendicular to the piezoelectric layer (1).

20. A piezoelectric sensor according to the preceding claim, **characterized in that** a preloaded resilient element is arranged between the piezoelectric layer (1) and the pressure plate.

## Revendications

1. Capteur piézoélectrique comportant un support de base (2), un capteur de mesure piézoélectrique disposé sur le support de base (2), une couche de recouvrement (3) recouvrant le capteur de mesure et un dispositif d'évaluation électronique (4), dans lequel le capteur de mesure est formé par une couche piézoélectrique (1), le support de base (2) présente une première couche de contact (5) en liaison électrique avec la couche piézoélectrique (1), la couche de recouvrement (3) présente une seconde couche de contact (6), connectée électriquement avec la couche piézoélectrique (1), et le dispositif d'évaluation électronique (4) est capable de déterminer une sollicitation mécanique de la couche piézoélectrique (1) en évaluant la différence du potentiel électrique entre la première couche de contact (5) et la seconde couche de contact (6), **caractérisé en ce que**
le capteur est constitué en épaisseur de feuille conjointement avec le dispositif d'évaluation électronique, dans lequel la couche piézoélectrique (1) présente une épaisseur inférieure à 1 mm et le dispositif d'évaluation électronique (4) est disposé à côté du capteur de mesure sur le support de base (2) conçu sous forme de feuille et fabriqué à partir d'un matériau élastique et n'amortissant que peu de vibrations.

2. Capteur piézoélectrique selon la revendication 1, **caractérisé en ce que** le support de base et la couche piézoélectrique sont reliés ensemble de manière à adhérer à plat.

3. Capteur piézoélectrique selon la revendication précédente, **caractérisé en ce que** l'épaisseur de la couche piézoélectrique (1) est inférieure à 10 µm.

4. Capteur piézoélectrique selon l'une quelconque des revendications précédentes, **caractérisé en ce que** le support de base (2) présente une couche porteuse fabriquée à partir d'un matériau non conducteur électrique, qui est pourvue de la première couche de contact (5) et sur laquelle le dispositif d'évaluation électronique (4) est disposé en plus de la couche piézoélectrique (1).

5. Capteur piézoélectrique selon l'une quelconque des revendications précédentes, **caractérisé en ce qu'**une zone de détection plane est constituée en construction sandwich en plus du dispositif d'évaluation électronique (4), dans laquelle le support de base (2) est pourvu dans la zone de détection de la première couche de contact (5), la couche piézoélectrique (1) est disposée sur la première couche de contact (5), connectée électriquement avec celle-ci, et la couche de recouvrement (3), qui présente la seconde couche de contact (6) conductrice orientée vers la couche piézoélectrique (1), est disposée dessus.

6. Capteur piézoélectrique selon l'une quelconque des revendications précédentes, **caractérisé en ce que** le support de base (2) et/ou la couche de recouvrement (3) sont formés par une feuille flexible, dont l'épaisseur est inférieure à 200 µm.

7. Capteur piézoélectrique selon l'une quelconque des revendications précédentes, **caractérisé en ce que** l'épaisseur de la première couche de contact (5) et l'épaisseur de la seconde couche de contact (6) sont respectivement inférieures à 70 µm.

8. Capteur piézoélectrique selon l'une quelconque des revendications précédentes, **caractérisé en ce qu'**il présente un boîtier (7) recevant le reste des composants.

9. Capteur piézoélectrique selon l'une quelconque des revendications précédentes, **caractérisé en ce que** le boîtier (7) est fabriqué par refonte du capteur avec du plastique.

10. Capteur piézoélectrique selon l'une quelconque des revendications précédentes, **caractérisé en ce que** le boîtier (7) est formé par une feuille supérieure et inférieure, qui sont reliées ensemble par une soudure de liaison faisant le tour du reste des pièces du capteur.

11. Capteur piézoélectrique selon l'une quelconque des revendications précédentes, **caractérisé en ce que** la première couche de contact (5) et la seconde couche de contact (6) sont formées par des feuilles minces d'un matériau métallique.

12. Capteur piézoélectrique selon la revendication précédente, **caractérisé en ce que** les feuilles de la première couche de contact (5) et de la seconde couche de contact (6) présentent pour le moins respectivement une extension de type câble, qui est reliée au dispositif d'évaluation électronique (4) en vue de sa mise en contact.

13. Capteur piézoélectrique selon l'une quelconque des revendications précédentes, **caractérisé en ce que** la première couche de contact (5) et la seconde couche de contact (6) sont subdivisées en segments séparés par des fentes isolantes électriquement et le dispositif d'évaluation électronique (4) est relié à chacun des segments de telle manière qu'il est capable de déterminer la différence de potentiel entre une paire de segments de la première couche de contact (5) et de la seconde couche de contact (6).

14. Capteur piézoélectrique selon l'une quelconque des revendications précédentes, **caractérisé en ce que** le dispositif d'évaluation électronique (4) présente un amplificateur programmable.

15. Capteur piézoélectrique selon l'une quelconque des revendications précédentes, **caractérisé en ce que** le dispositif d'évaluation électronique (4) présente une interface (9) en vue du raccordement à un bus de terrain, en particulier avec un bus CAN.

16. Capteur piézoélectrique selon l'une quelconque des revendications précédentes, **caractérisé en ce que** le dispositif d'évaluation électronique (4) présente un processeur de signaux et une mémoire de programme avec logiciel enregistré dessus, dans lequel le logiciel destiné à la mesure du bruit de structure au moyen de l'analyse fréquentielle de la différence de potentiel mesurée est capable de détecter un changement de fréquence inhabituel.

17. Capteur piézoélectrique selon la revendication précédente, **caractérisé en ce que** le logiciel présente un sous-programme d'étalonnage qui détermine après une période prédéfinie la variation dans le temps du bruit de structure en tant que cas normal et prend celui-ci pour base pour les mesures de contrôle postérieures, dans lequel le signal mesuré est comparé à celui du cas normal et le logiciel est capable d'émettre un signal en cas d'écarts supérieurs à un seuil de tolérance prédéfini.

18. Capteur piézoélectrique selon l'une quelconque des revendications précédentes, **caractérisé en ce qu'**il présente un second dispositif d'évaluation électronique externe (8), qui est relié au dispositif d'évaluation électronique (4) par l'intermédiaire d'une liaison numérique et présente une interface (9) destinée au raccordement à un système de bus de terrain.

19. Capteur piézoélectrique selon l'une quelconque des revendications précédentes, **caractérisé en ce qu'**il présente une plaque de pression disposée parallèlement à la couche piézoélectrique (1) et qui est guidée de manière mobile dans la direction perpendiculaire à la couche piézoélectrique (1).

20. Capteur piézoélectrique selon la revendication précédente, **caractérisé en ce qu'**un élément élastique sous précontrainte est disposé entre la couche piézoélectrique (1) et la plaque de pression.
